# EUROPEAN PATENT APPLICATION

(11) **EP 1 845 764 A1**
(43) Date of publication of application: **17.10.2007**
(21) Application number: 06112665.2
(22) Date of filing: 13.04.2006
(51) Int. Cl.: H05K 7/10

(54) **IC element socket**

(71) Applicant: Lih Duo International Co., Ltd., Wu Gu Shiang, Taipei Hsien (TW)
(72) Inventor: Wang, Sung-Lai, Wu Gu Shiang, Taipei Hsien (TW)
(74) Representative: Beck, Michael Rudolf

(57) **Abstract**

An IC element socket (20) applicable for mounting either LGA IC element (60) or BGA IC element (70) in detachable manner which comprises a socket seat (21) fixed on an electronic circuit board (40), and the socket seat (21) has a recession (22) having formed a group of inserting holes (23) arranged in matrix form of rows and columns and each inserting hole (23) has an electric conducting spring (30) freely installed inside by way of having its one end electrically connected to the electronic circuit board (40) and the other end freely extended outside its corresponding inserting hole (23) to form a free moving electric connecting terminal; the inserting hole (23) of the IC element socket (20) shall further provide position alignment effect to BGA IC element (70) which has tin balls (71) on bottom side.

## Description

### BACKGROUND OF THE INVENTION

### 1. Field of the Invention

The invention relates to an IC element socket, particularly the IC element socket using electric conducting spring as electric conductivity element and applicable for mounting either BGA IC element or LGA IC element.

### 2. Description of the Prior Art

For purpose of lexicography, the general meaning of the term "IC element", as used herein, refers to the central processing unit (CPU), chipset or graphic processing unit (GPU).

The manner of mounting IC element to an electronic circuit board can be classified into two types of permanently fixed type and detachable type.

For example, the IC element such as CPU, chipset or GPU can be fixed on the electronic circuit board by joining the lead of the IC element and the circuit on the circuit board directly by soldering to form electric connection between the IC element and the circuit. Or, a socket is pre-installed on the circuit of the electronic circuit board, and then the IC element can be mounted on the socket in detachable manner to achieve electric connection between the IC element and the circuit.

The advantage of pre-installing a socket on electronic circuit board is that the IC element mounted on the socket can be easily removed and replaced with a new one whenever there is a damaged IC element to be replaced or an old IC to be upgraded.

And, according to the structural package of IC element, the IC element can be classified into Pin Grid Array IC element 50 abbreviated as PGA IC element 50 and shown in Fig. 1, the Land Grid Array IC element 60 abbreviated as LGA IC element 60 and shown in Fig. 2, and the Ball Grid Array IC element 70 abbreviated as BGA IC element 70 and shown in Fig. 3 respectively.

Therefore, if the socket is adopted for fixing the IC element on an electronic circuit board, the socket must be provided with a special structure designed to fit the structural package of IC element. In other words, a socket specially designed for mounting PGA IC element 50 shall not be used for mounting LGA IC element or BGA IC element, and vice versa. This has caused the socket unable to be commonly used by all kinds of IC element.

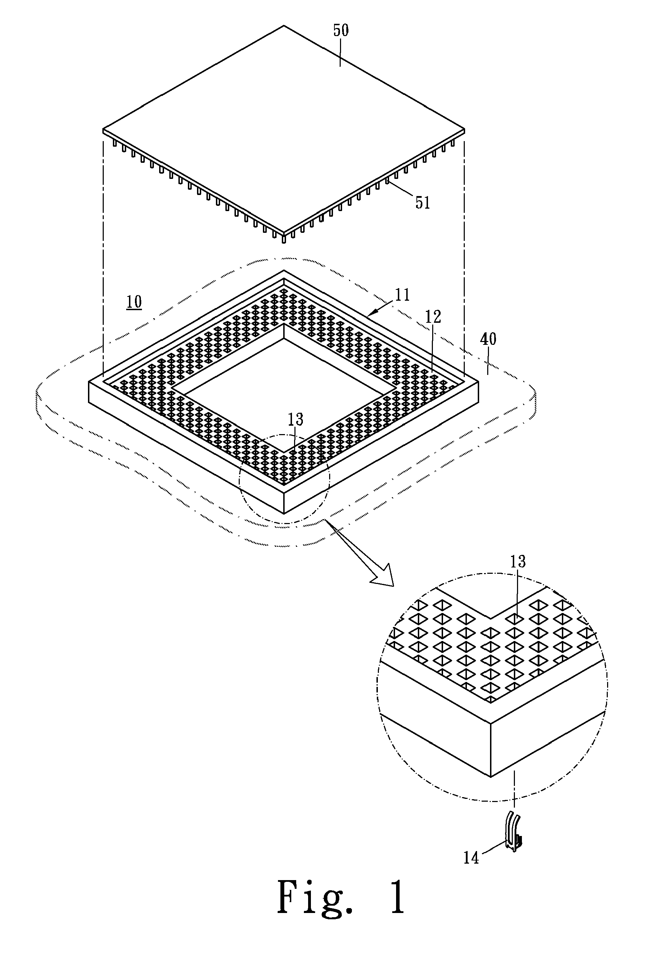

Take a socket 10 for PGA IC element 50 shown in Fig. 1 as example, the socket 10 having a socket seat 11 is fixed on the electronic circuit board 40, and the socket seat 11 has a recession 12 for accommodating the PGA IC element 50. The recession 12 has multiple number of inserting holes 13, and each inserting hole 13 has a connecting terminal 14 made of metal inside which connecting terminal 14 has its lower end positioned in touch with the circuit (not shown) of the electronic circuit board 40 to form an electric conductivity.

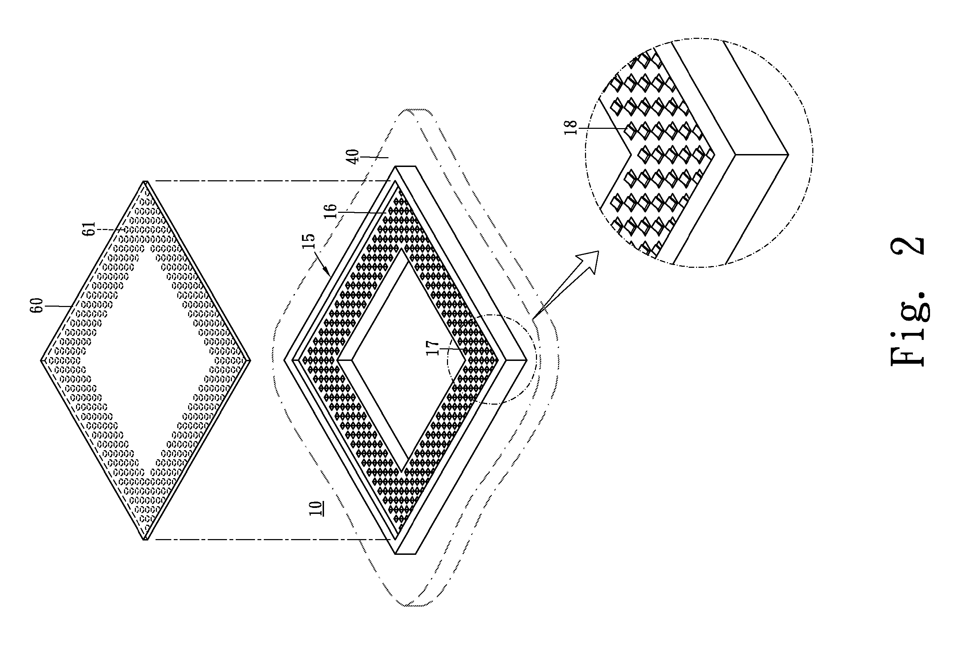

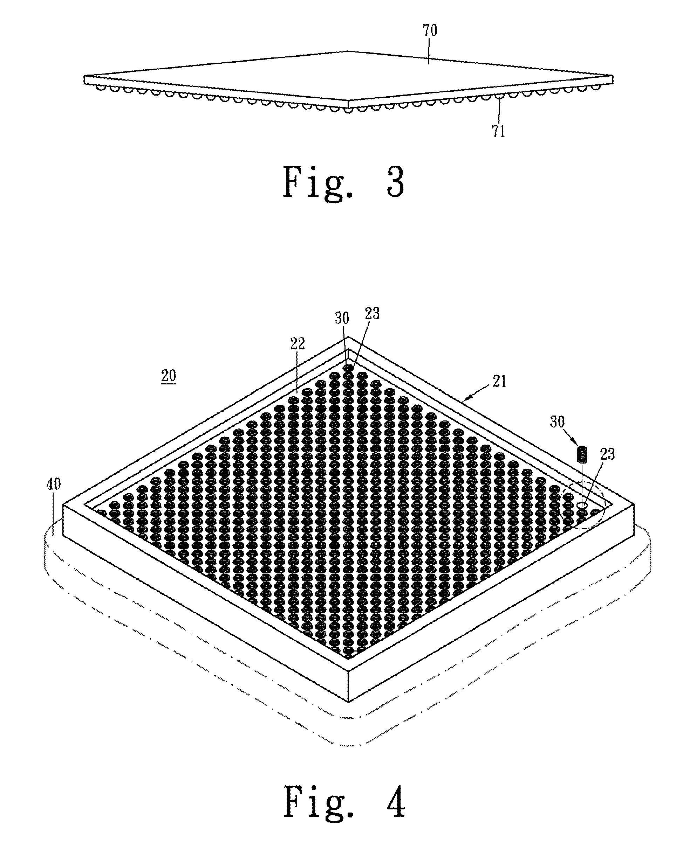

When PGA IC element 50 is mounted into the socket 10 in detachable manner, the connecting lead 51 of the PGA IC element 50 is inserted into the corresponding inserting hole 13, and touches the upper end of the connecting terminal 14 of the socket 10 to form an electric connection and further to effect an electric conductivity between the PGA IC element 50 and the electronic circuit board 40. However, this kind of the socket 10 is unable to be used for mounting LGA IC element 60 as shown in Fig. 2 or BGA IC element 70 as shown in Fig. 3.

Take another socket 10 for LGA IC element 60 shown in Fig. 2 as another example, the socket 10 having a socket seat 15 is fixed on the electronic circuit board 40, and the socket seat 15 has a recession 16 for accommodating the LGA IC element 60. The recession 16 has multiple number of inserting holes 17, and each inserting hole 17 has a metal spring plate 18 which has its lower end positioned in touch with the circuit (not shown) of the electronic circuit board 40 to form an electric conductivity and has its upper end extended to the outside of the inserting hole 17.

When the LGA IC element 60 is mounted into the socket 10 in detachable manner, the connecting terminal 61 of the LGA IC element 60 is positioned to press at the metal spring plate 18 of the socket 10 to form an electric connection and further to effect electric conductivity between the LGA IC element 60 and the electronic circuit board 40.

However, the metal plate 18 used on the conventional socket 10 has the drawbacks of poor elasticity and spring back capability. When in practical use the metal spring plate 18 is repeatedly pressed by the connecting terminal 61 of the LGA IC element 60 that always causes permanent deformation of the spring plate 18 due to fatigue, therefore, the upper part of the spring plate 18 which extends to the outside of the inserting hole 17 is unable to return to its original position that results in unstable electric connection or distortion of signal transmitting.

### SUMMARY OF THE INVENTION

The major purpose of the invention is to disclose an IC element socket which adopts electric conducting spring having good elastic property and high endurable service life as an electric connecting element which, in addition to the advantage of able to be used repeatedly for a long period of time, can be commonly used for mounting different types of IC element such as BGA IC element or LGA IC element by using electric conducting spring. Especially, it can also provide the effect of position alignment when used for mounting BGA IC element.

The IC element socket is fixed on an electronic circuit board, and has an accession for mounting either LGA IC element or BGA IC element in detachable manner, and the accession has multiple number of inserting holes with position arranged in matrix form of columns and rows. Inside each inserting hole is an electric conducting spring which one end is in electric contact with the circuit on the electronic circuit board and the other end is extended to the outside of the inserting hole to form an elastic connecting terminal; when either LGA IC element or BGA IC element is mounted into the IC element socket of the invention, the electric conducting spring of the IC element socket will form tight contact with the terminals formed on the bottom side of the LGA IC element or with the tin balls formed on the bottom side of the BGA IC element that can achieve a reliable and stable electric connection between the electronic circuit board and the LGA IC element or BGA IC element.

Besides, the structure of the recession of the IC element socket can also provide position alignment effect to BGA IC element which has tin balls formed on the bottom side.

### BRIEF DESCRIPTION OF THE DRAWINGS

Fig. 1 is the schematic drawing of a conventional socket specially designed for mounting PGA IC element.
Fig. 2 is the schematic drawing of another conventional socket specially designed for mounting LGA IC element.
Fig. 3 is the schematic drawing of a BGA IC element having tin balls formed on the bottom side.
Fig. 4 is an enlarged schematic drawing of an IC element socket of the invention.

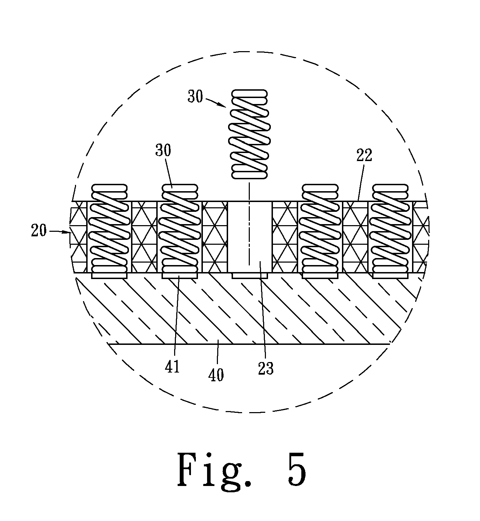

Fig. 5 is an enlarged cross-sectional view of the inserting hole of the IC element socket shown in Fig. 4 to show there has an electric conducting spring installed inside the inserting hole.

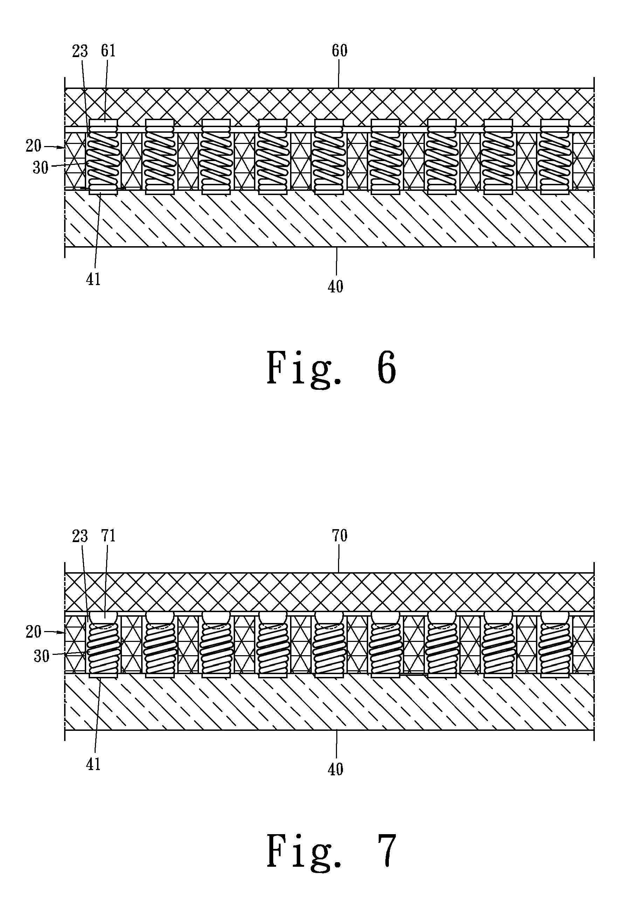

Fig. 6 is the schematic drawing for illustrating the application of the IC element socket of the invention in mounting the LGA IC element.
Fig. 7 is the schematic drawing for illustrating another application of the IC element socket of the invention in mounting BGA IC element and the effect of position alignment.

### DESCRIPTION OF THE PREFERRED EMBODIMENT

As shown in Figs. 4 and 5, the IC element socket 20 of the invention comprises a socket seat 21 which has a recession 22 for mounting either LGA IC element or BGA IC element. The recession 22 has a group of inserting holes 23 with position arranged in matrix form of rows and columns, and an electric conducting spring 30 is installed in each of inserting holes 23.

The electric conducting spring 30 used on the IC element socket 20 is made of the material having excellent elasticity and electric conducting effect, so that it shall restore to its original length without any permanent deformation after long period of time under compression, i.e., the IC element socket 20 of the invention has the advantage of high durability for long period and repeated use.

The IC element socket 20 disclosed in the invention is fixed on an electronic circuit board 40 with one end of its electric conducting spring 30 positioned in contact with the circuit connecting pad 41 on the circuit board 40, while another end of the electric conducting spring 30 extends to the outside of the inserting hole 23 and is maintained in a state to move freely to form an electric connecting terminal.

The IC element socket 20 of the invention may be installed on different kinds of electronic circuit board 40 which is designed for specific purpose such as for mounting CPU, chipset or GPU in detachable manner. When these kinds of IC element are going to be replaced due to damage or upgrading, the IC element socket 20 of the invention shall provide the advantage of easy replacing the old IC element.

As shown in Figs. 6 and 7, the IC element socket 20 shall be commonly used for mounting either LGA IC element 60 having connecting terminals 61 formed on bottom side or BGA IC element 70 having tin balls 71 formed on bottom side onto the electronic circuit board 40 in detachable manner.

When LGA IC element 60 or BGA IC element 70 is mounted into the recession 22 of the IC element socket 20, the free moving end of the electric conducting spring 30 of the IC element socket 20 will touch and press at the connecting terminal 61 formed on the bottom side of the LGA IC element 60 or at the tin balls 71 formed on the bottom side of the BGA IC element 70, and form reliable and stable electric connection between the electronic circuit board 40 and the LGA IC element 60 or BGA IC element 70 to achieve the desired function.

In addition, as shown in Fig. 7, the inserting hole 23 of the IC element socket 20 has another effect of aligning the position of BGA IC element 70 having tin balls 71 formed on bottom side. When the BGA IC element 70 is mounted into the recession 22 of the IC element socket 20 of the invention, the tin balls 71 formed on bottom side of the BGA IC element 70 will press at the electric conducting spring 30 of the IC element socket 20 and push the electric conducting spring 30 back into the inserting hole 23 until the tin balls 71 of the BGA IC element 70 is set inside the inserting hole 23 that can provide the effect of position alignment to the BGA IC element 70 by employing the tin balls 71 on its bottom side.

However, the description as disclosed above is only the example of the preferred embodiment of the invention, any simple modification, embellishment, improvement or change that gives the effect equivalent to or the same as that of the present invention, and is obvious to those skilled in the art shall be covered by the appended claims of the invention.

## Claims

1. An IC element socket (20) comprising a socket seat (21) fixed on an electronic circuit board (40), the socket seat (21) having a recession (22) for mounting either a LGA IC element (60) or a BGA IC element (70) in a detachable manner, **characterized in that** the recession (22) has a group of inserting holes (23) with their position arranged in matrix form of rows and columns, and each inserting hole (23) has an electric conducting spring (30) freely installed inside by way of having its one end electrically connected to the electronic circuit board (40) and the other end freely extended outside its corresponding inserting hole (23) to form a free moving electric connecting terminal.
